(19) **Europäisches Patentamt**
**European Patent Office**
**Office européen des brevets**

(11) **EP 3 197 250 A1**

(12) **EUROPEAN PATENT APPLICATION**
published in accordance with Art. 153(4) EPC

(43) Date of publication:
26.07.2017 Bulletin 2017/30

(51) Int Cl.:
*H05K 3/20* (2006.01)    *G06F 3/041* (2006.01)
*G06F 3/044* (2006.01)    *H05K 9/00* (2006.01)

(21) Application number: 16789545.7

(86) International application number:
PCT/JP2016/063384

(22) Date of filing: 28.04.2016

(87) International publication number:
WO 2016/178409 (10.11.2016 Gazette 2016/45)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 01.05.2015 JP 2015093899

(71) Applicant: Fujikura Ltd.
Tokyo 135-8512 (JP)

(72) Inventor: ISHII, Masaaki
Sakura-shi
Chiba 285-8550 (JP)

(74) Representative: Ter Meer Steinmeister & Partner
Patentanwälte mbB
Artur-Ladebeck-Strasse 51
33617 Bielefeld (DE)

(54) **WIRING BODY, WIRING SUBSTRATE, AND TOUCH SENSOR**

(57)    A wiring body (4) includes an adhesive layer (5) and a mesh-like electrode layer (6) having a shape of a mesh formed by fine wires (64) intersecting each other, and formed on the adhesive layer (5). The mesh-like electrode layer (6) includes an intersection region (T1) intersecting fine wires (64) each other, and a non-intersection region (T2) corresponding to a region except for the intersection region (T1), and a depression (65) recessed toward the adhesive layer (5) is formed in the intersection region (T2).

FIG. 7

**Description**

TECHNICAL FIELD

The present invention relates to a wiring body, a wiring board, and a touch sensor.

With regard to designated states that accept incorporation by reference of literature, content described in Japanese Patent Application No. 2015-093899, filed on May 1, 2015, is incorporated in this specification, and used as a part of description of this specification.

BACKGROUND ART

There is a known technology for forming a circuit pattern by transferring organic metal ink to a target print body through a hardening resin after filling a groove portion of intaglio with the organic metal ink (for example, see Patent Document 1).

CITATION LIST

PATENT DOCUMENT

Patent Document 1: JP 04-240792 A

SUMMARY OF THE INVENTION

PROBLEM TO BE SOLVED BY THE INVENTION

In the above-described technology, a mechanical joining force between a conductor layer and an insulating layer covering the conductor layer is weak. Thus, an adhesive property between the conductor layer and the insulating layer is low, and there is a problem that separation may occur between the conductor layer and the insulating layer.

An issue to be solved by the invention is to provide a wiring body, a wiring board, and a touch sensor capable of suppressing separation between a conductor layer and an insulating layer.

MEANS FOR SOLVING PROBLEM

[1] A wiring body according to the invention includes a first resin layer, and a conductor layer having a shape of a reticulation formed by fine wires intersecting each other, and formed on the first resin layer, in which the conductor layer includes an intersection region intersecting fine wires each other, and a non-intersection region corresponding to a region except for the intersection region, and the conductor layer has a depression recessed toward the first resin layer in the intersection region.

[2] In the above invention, the following Formula (1) may be satisfied:

$$H_1 \times 1/2 \leq H_2 < H_1 \ldots (1)$$

in the Formula (1), $H_1$ denotes an average height of the conductor layer in the non-intersection region, and $H_2$ denotes an average height of the conductor layer in the depression.

[3] In the above invention, the fine wires may include a first surface coming into contact with the first resin layer, and a second surface corresponding to a surface on an opposite side from the first surface, and the second surface may include a flat portion in the non-intersection region.

[4] In the above invention, the second surface may be include a protrusion protruding in a direction away from the first resin layer and provided to at least one of both end portions of the second surface in a cross section of the fine wires in a short direction, and have a protrusion protruding in a direction away from the first resin layer, and the protrusion included in one of the fine wires intersecting each other and the protrusion included in another one of the fine wires intersecting each other may be continuously connected to each other in a portion in which the fine wires intersect each other.

[5] In the above invention, a height of the conductor layer may gradually decrease toward the depression in the intersection region.

[6] In the above invention, an external shape of the fine wires in a cross section in a short direction may include two straight line-shaped side surfaces inclined such that the side surfaces approach each other as being separated from the first resin layer.

[7] In the above invention, the wiring body may further include a second resin layer covering the conductor layer, and the conductor layer may be interposed between the first and second resin layers.

[8] A wiring board according to the invention includes the above-described wiring body and a support that supports the wiring body.

[9] In the above invention, the wiring board may further include a third resin layer interposed between the wiring body and the support.

[10] A touch sensor according to the invention includes the above-described wiring board.

EFFECT OF THE INVENTION

According to the invention, a contact area between a conductor layer and an insulating layer covering the conductor layer increases due to a depression formed in an intersection region. In this way, an adhesive property between the conductor layer and the insulating layer is improved, and separation between the conductor layer and the insulating layer is suppressed.

## BRIEF DESCRIPTION OF DRAWINGS

Fig. 1 is a perspective view illustrating a touch sensor according to an embodiment of the invention.

Fig. 2 is a plan view illustrating a wiring board according to an embodiment of the invention.

Fig. 3 is a cross-sectional view taken along III-III line of Fig. 2.

Fig. 4 is a diagram illustrating a modified example of a fine wire according to an embodiment of the invention, and is a cross-sectional view corresponding to a cross section along III-III line of Fig. 2.

Fig. 5 is a cross-sectional view for description of the fine wire according to the embodiment of the invention;

Fig. 6 is a partial enlarged view of a VI portion of Fig. 2.

Fig. 7 is a cross-sectional view taken along VII-VII line of Fig. 2.

Fig. 8 is a perspective view of a portion, in which fine wires according to an embodiment of the invention intersects each other, viewed obliquely from above.

Fig. 9 is a cross-sectional view taken along IX-IX line of Fig. 2.

Fig. 10(a) and Fig. 10(b) are diagrams illustrating a method of manufacturing the wiring board according to an embodiment of the invention, and cross-sectional views for description of a method of preparing intaglio.

Fig. 11 is a diagram illustrating the intaglio according to an embodiment of the invention, and a cross-sectional view of a state in which a convex portion of the intaglio is included.

Fig. 12(a) to Fig. 12(f) are diagrams illustrating the method of manufacturing the wiring board according to the embodiment of the invention.

## MODE(S) FOR CARRYING OUT THE INVENTION

Hereinafter, an embodiment of the invention will be described based on drawings.

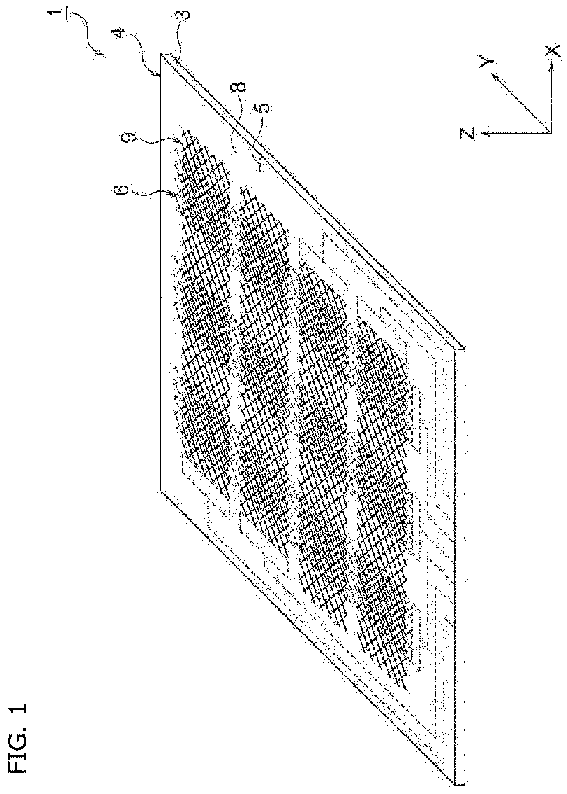

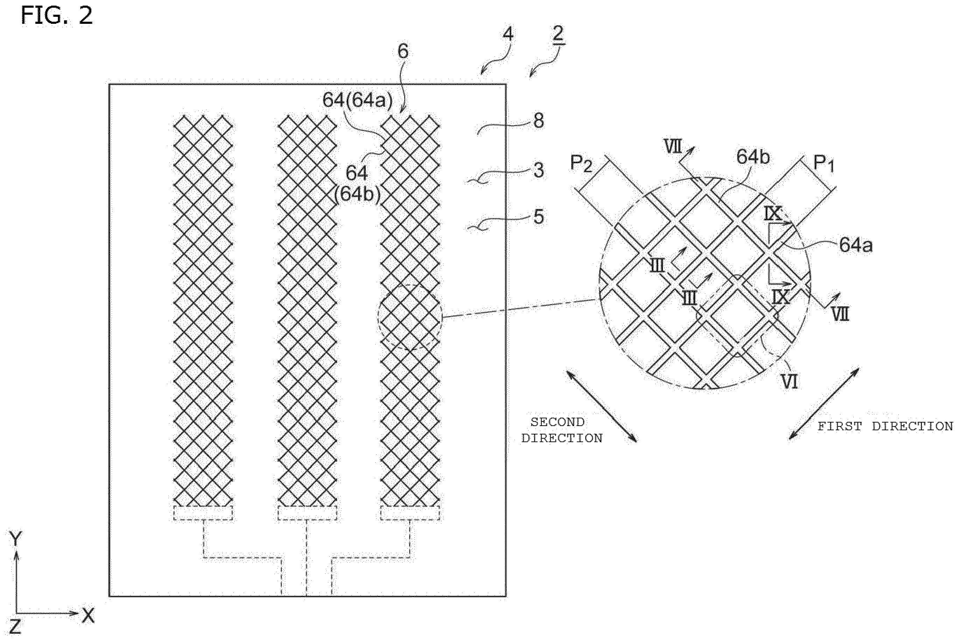

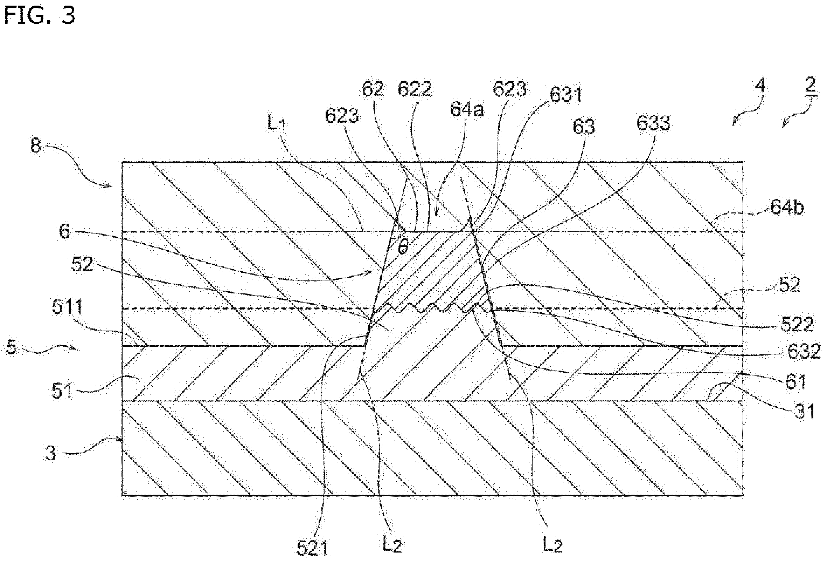

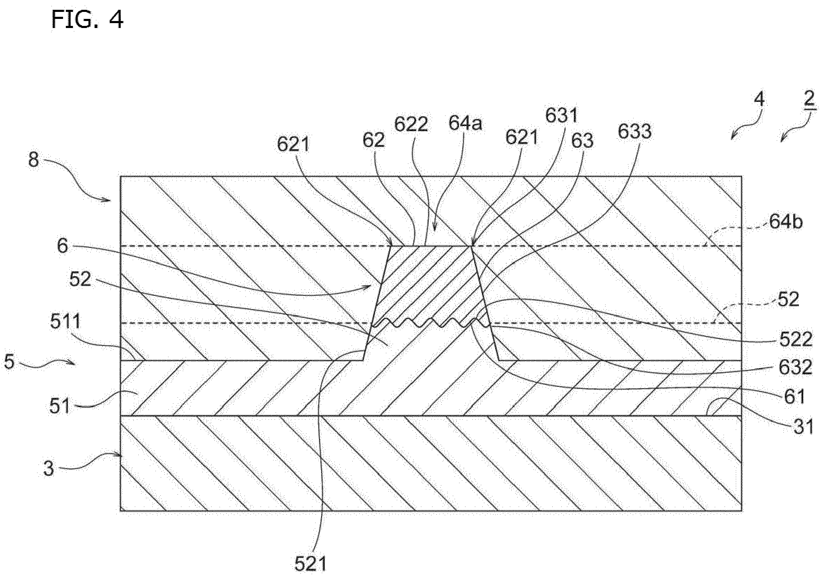

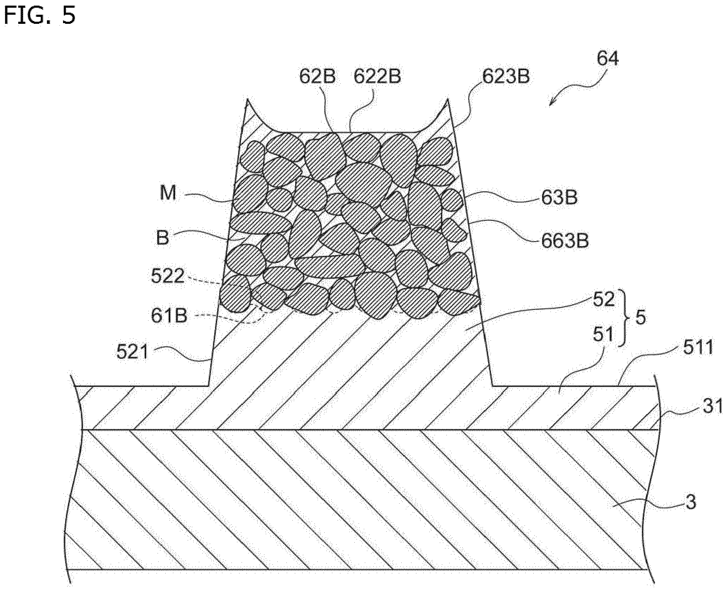

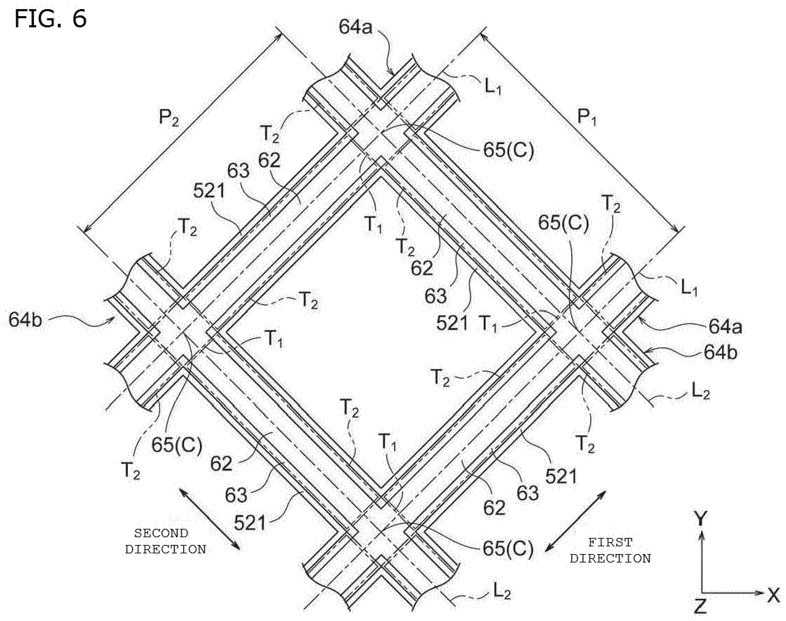

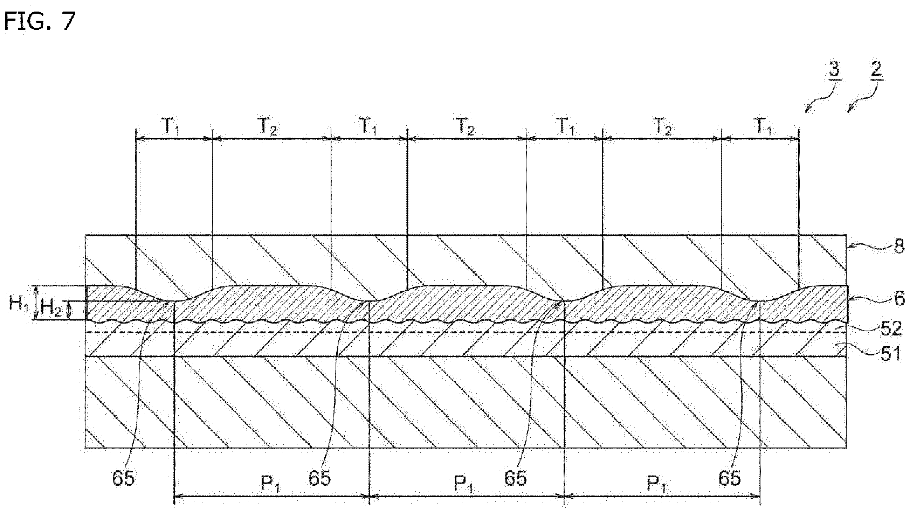

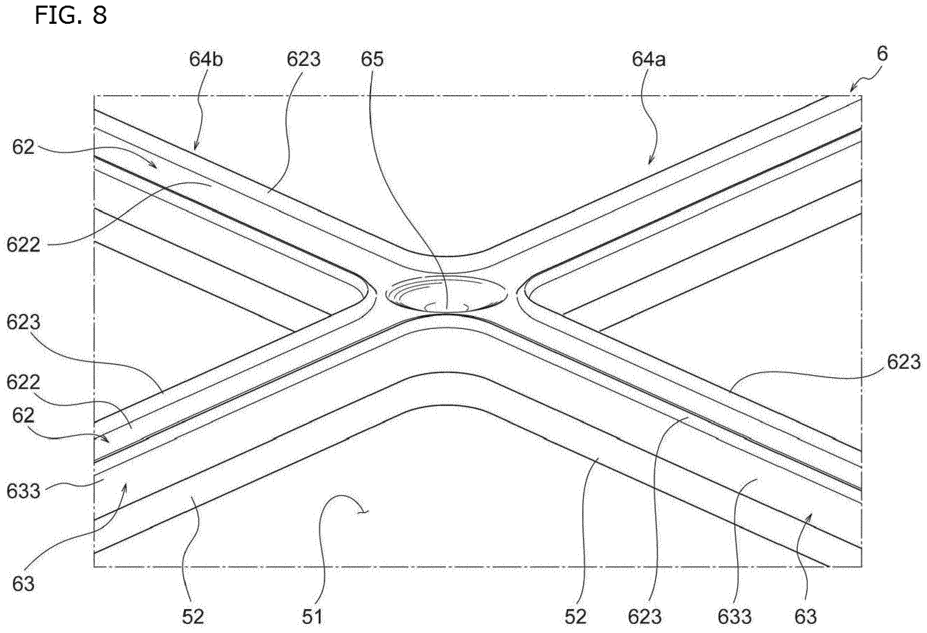

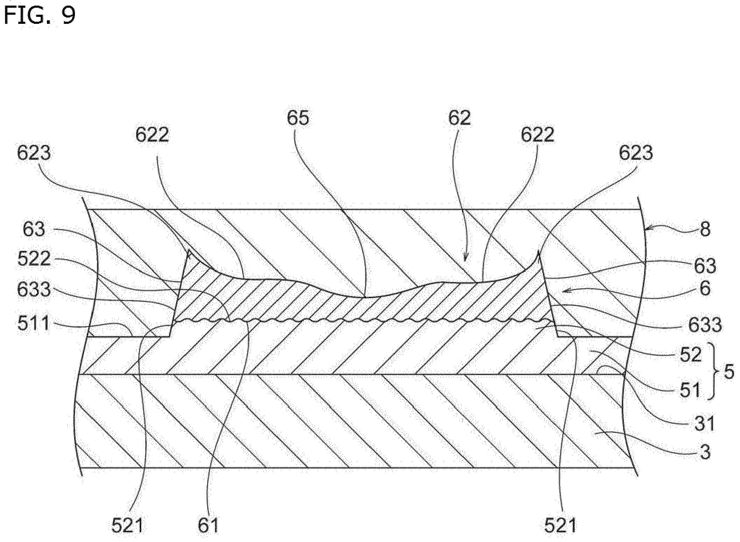

Fig. 1 is a perspective view illustrating a touch sensor according to an embodiment of the invention. Fig. 2 is a plan view illustrating a wiring board according to an embodiment of the invention. Fig. 3 is a cross-sectional view taken along III-III line of Fig. 2. Fig. 4 is a diagram illustrating a modified example of a fine wire according to an embodiment of the invention, and is a cross-sectional view corresponding to a cross section along III-III line of Fig. 2. Fig. 5 is a cross-sectional view for description of the fine wire according to the embodiment of the invention. Fig. 6 is a partial enlarged view of a VI portion of Fig. 2. Fig. 7 is a cross-sectional view taken along VII-VII line of Fig. 2. Fig. 8 is a perspective view of a portion, in which fine wires according to an embodiment of the invention intersects each other, viewed obliquely from above. Fig. 9 is a cross-sectional view taken along IX-IX line of Fig. 2.

For example, a touch sensor 1 including a wiring body 4 of the present embodiment is a touch input device used for a touch panel or a touch pad corresponding to a capacitive sensing method, etc. A display device such as a liquid crystal display, an organic electro luminescence (EL) display, electronic paper, etc. is incorporated in the touch input device. As illustrated in Fig. 1 and Fig. 2, the touch sensor 1 includes a wiring board 2 that includes a substrate 3 and the wiring body 4, and a mesh-like electrode layer 9 stacked on a resin layer 8 of the wiring body 4.

A mesh-like electrode layer 6 included in the wiring body 4 corresponds to a plurality of (three in the present embodiment) detection electrodes, each of which extends in a Y direction. Further, the mesh-like electrode layer 9 is disposed to face the mesh-like electrode layer 6, and corresponds to a plurality of (four in the present embodiment) detection electrodes, each of which extends in an X direction. In the touch sensor 1, for example, the mesh-like electrode layers 6 and 9 are connected to an external circuit through a lead-out wire (indicated by a broken line in Fig. 1). In addition, a predetermined voltage is periodically applied between the mesh-like electrode layers 6 and 9, and an operation position (contact position) of an operator on the touch sensor 1 is distinguished based on a change in electrostatic capacity at each intersection point of the two mesh-like electrode layers 6 and 9.

In the present embodiment, the mesh-like electrode layer 9 has a similar configuration to that of the mesh-like electrode layer 6. Therefore, in this specification, a detailed description of the mesh-like electrode layer 9 will be omitted. The "touch senor 1" in the present embodiment corresponds to an example of a "touch sensor" in the invention, and the "wiring board 2" in the present embodiment corresponds to an example of a "wiring board" in the invention.

Examples of a material of the substrate 3 may include polyethylene terephthalate (PET), polyethylene naphthalate (PEN), polyimide resin (PI), polyetherimide resin (PEI), polycarbonate (PC), polyether ether ketone (PEEK), liquid crystal polymer (LCP), cycloolefin polymer (COP), silicone resin (SI), acrylic resin, phenol resin, epoxy resin, green sheet, glass, etc. An easily adhesive layer or an optical adjustment layer may be formed in the substrate. When the wiring board 2 is used for an electrode substrate of the touch panel, a transparent material is selected as a material contained in the substrate 3. The "substrate 3" in the present embodiment corresponds to an example of a "support" in the invention.

The wiring body 4 is formed on a main surface 31 of the substrate 3 and supported by the substrate 3. The wiring body 4 includes an adhesive layer 5, the mesh-like electrode layer 6, and the resin layer 8. The "wiring body 4" in the present embodiment corresponds to an example of a "wiring body" in the invention.

The adhesive layer 5 serving as a resin layer in the present embodiment is a member bonding and fixing the substrate 3 and the mesh-like electrode layer 6 to each other. Examples of a material contained in the adhesive layer 5 may include a UV-curing resin, a thermosetting resin, or a thermoplastic resin such as epoxy resin, acrylic resin, polyester resin, urethane resin, vinyl resin, silicone resin, phenol resin, polyimide resin, etc. As illustrated in Fig. 3, the adhesive layer 5 in the present embodiment includes a smooth portion 51 provided on the main surface 31 of the substrate 3 at a substantially constant thickness, and a support portion 52 formed on the smooth portion 51.

The smooth portion 51 is uniformly provided to cover the main surface 31 of the substrate 3, and a main surface 511 of the smooth portion 51 is a surface substantially parallel to the main surface 31 of the substrate 3. The thickness of the smooth portion 51 is preferably within a range of 5 $\mu$m to 100 $\mu$m. The support portion 52 is formed between the smooth portion 51 and the mesh-like electrode layer 6, and formed to protrude in a direction away from the substrate 3 (+Z direction in Fig. 2). For this reason, a thickness (height) of the adhesive layer 5 in a portion in which the support portion 52 is provided is larger than the thickness (height) of the adhesive layer 5 in the smooth portion 51. The adhesive layer 5 comes into contact with the mesh-like electrode layer 6 (specifically, a contact surface 61 (described below)) on a contact surface 522 corresponding to an upper surface of the support portion 52.

As illustrated in Fig. 3, the contact surface 522 has a concavo-convex shape which is complementary to the contact surface 61 having a concavo-convex shape. As illustrated in Fig. 7, the contact surface 522 and the contact surface 61 have concavo-convex shapes complementary to each other in a cross section of a fine wire 64 (described below) included in the mesh-like electrode layer 6 in an extending direction. In Fig. 3 and Fig. 7, the concavo-convex shapes of the contact surface 522 and the contact surface 61 are exaggeratingly illustrated to describe the wiring body 4 of the present embodiment in an easily understood manner.

The support portion 52 has a straight line shape in a section view in a short direction, and has two side surfaces 521 and 521 inclined such that the side surfaces 521 and 521 approach each other as being separated from the substrate 3. In the present embodiment, a "cross section in a short direction" refers to a cross section in a direction orthogonal to an extending direction of a first fine wire 64a (described below) of the mesh-like electrode layer 6, or a cross section in a direction orthogonal to an extending direction of a second fine wire 64b (described below) of the mesh-like electrode layer 6.

The mesh-like electrode layer 6 is stacked on the support portion 52 of the adhesive layer 5, and formed to protrude in the +Z direction. In the present embodiment, the mesh-like electrode layer 6 is used as a detection electrode of the touch sensor 1. The "mesh-like electrode layer 6" in the present embodiment corresponds to an example of a "conductor layer" in the invention.

The mesh-like electrode layer 6 of the present embodiment includes a conductive powder and a binder resin. In the mesh-like electrode layer 6, the conductive powder is present in the binder resin by being substantially uniformly dispersed. Conductivity is assigned to the mesh-like electrode layer 6 when conductive powders come into contact with each other. Examples of the conductive powder contained in the mesh-like electrode layer 6 may include a metal material such as silver, copper, nickel, tin, bismuth, zinc, indium, palladium, etc., or a carbon-based material such as graphite, carbon black (furnace black, acetylene black, Ketjen black), carbon nanotube, carbon nanofiber, etc. In addition to the conductive powder, it is possible to use metal salt corresponding to salt the above-mentioned metal material.

For example, a conductive particle having a particle diameter $\varphi$ of 0.5 $\mu$m or more and 2 $\mu$m or less (0.5 $\mu$m $\leq \varphi \leq$ 2 $\mu$m) depending on a width of the fine wire 64 included in the mesh-like electrode layer 6 may be used as a conductive particle contained in the mesh-like electrode layer 6. It is preferable to use conductive particles having an average particle diameter $\varphi$ which is half or less the width of the fine wire 64 included in the mesh-like electrode layer 6 in terms of stabilizing electrical resistivity in the mesh-like electrode layer 6. In addition, it is preferable to use a particle, whose specific surface area measured by a BET method is 20 m²/g or more, as the conductive particle.

When relatively small electrical resistivity of a certain value or less is required for the mesh-like electrode layer 6, the metal material is preferably used as the conductive particle. However, when relatively large electrical resistance value of a certain value or more is allowed for the mesh-like electrode layer 6, the carbon-based material is preferably used as the conductive particle. Using the carbon-based material as the conductive particle is preferable in terms of improving haze or total light reflectance of a mesh film.

In the present embodiment, optical transparency is assigned to the mesh-like electrode layer 6 by forming the electrode layer in a mesh shape. In this case, it is possible to use a metal material such as silver, copper, or nickel, or an opaque electrically conductive material excellent in conductivity such as the above-mentioned carbon-based material (an opaque metal material and an opaque carbon-based material) as an electrically conductive material included in the mesh-like electrode layer 6.

Examples of the binder resin contained in the mesh-like electrode layer 6 may include acrylic resin, polyester resin, epoxy resin, vinyl resin, urethane resin, phenol resin, polyimide resin, silicone resin, fluoride resin, etc. The binder resin may be omitted from the material included in the mesh-like electrode layer 6.

The mesh-like electrode layer 6 is formed by applying and hardening conductive paste. Specific examples of the conductive paste may include conductive paste configured by mixing conductive particles, binder resin, water, or a solvent and various addition agents. Examples of the solvent contained in the conductive paste may include α-terpineol, butyl carbitol acetate, butyl carbitol, 1-decanol, butyl cellosolve, diethylene glycol monoethyl ether acetate, tetradecane, etc.

As illustrated in Fig. 2, the mesh-like electrode layer 6 of the present embodiment is configured by allowing first and second fine wires 64a and 64b having conductivity to intersect each other, and has a mesh shape in which a rectangle is repeated as a whole. The "fine wires 64a and 64b" in the present embodiment correspond to an example of a "fine wire" in the invention. In description below, the "first fine wire 64a" and the "second fine wire 64b" are collectively referred to as the "fine wire 64" as necessary.

As illustrated in Fig. 3, an external shape of the fine wire 64 of the present embodiment includes the contact surface 61, a top surface 62, and two side surfaces 63 and 53. The contact surface 61 is a surface coming into contact with the adhesive layer 5 (specifically, the contact surface 522). The mesh-like electrode layer 6 of the present embodiment is supported by the substrate 3 through the adhesive layer 5. In this case, the contact surface 61 is a surface positioned on the substrate 3 side with respect to the top surface 62. In addition, the contact surface 61 is a surface having a concave-convex shape including fine irregularities in a cross section in a short direction. The concavo-convex shape of the contact surface 61 is formed based on surface roughness of the contact surface 61. The surface roughness of the contact surface 61 will be described below in detail.

Meanwhile, the top surface 62 is a surface on an opposite side from the contact surface 61. The top surface 62 includes a top surface flat portion 622 having a straight line shape. In a cross section of the mesh-like electrode layer 6 in a width direction, a width of the top surface flat portion 622 is half or more a width of the top surface 62. In the present embodiment, a substantially whole top surface 62 corresponds to the top surface flat portion 622. Flatness of the top surface flat portion 622 is 0.5 μm or less. The flatness may be defined by the JIS method (JIS B0621 (1984)).

The flatness of the top surface flat portion 622 is obtained using a non-contact measurement scheme using laser light. Specifically, a measuring object is irradiated with belt-shaped laser light, and an image of reflected light thereof is formed on an image pick-up device (for example, a two-dimensional (2D) CMOS) to measure the flatness. A scheme (maximum deflection-type flatness) is used as a scheme of calculating the flatness to set planes passing through three points separated from one another as much as possible on a target plane, and calculate a maximum value of deviations thereof as the flatness. A scheme of measuring or calculating the flatness is not particularly restricted to the above-described schemes. For example, a scheme of measuring the flatness may correspond to a contact-type measurement scheme using a dial gauge, etc. In addition, a scheme (maximum tilt-type flatness) may be used as a scheme of calculating the flatness to calculate a value of a gap, which is generated when a target plane is interposed between parallel planes, as the flatness.

The top surface 62 includes the top surface flat portion 622 in a non-intersection region T2 (described below). The top surface 62 in the non-intersection region T2 is set to a surface substantially parallel to the main surface 31 of the substrate 3 (or a surface of the adhesive layer 5 facing the main surface 31). The "top surface flat portion 62" in the present embodiment corresponds to an example of a "flat portion" in the invention.

The top surface 62 includes a protrusion 623. The protrusion 623 is provided at both ends of the top surface 62 in a section view of the fine wire 64 in a short direction. The invention is not particularly restricted to the above description, and the protrusion 623 may be provided only at one end portion of the top surface 62 in the section view of the fine wire 64 in the short direction. The protrusion 623 protrudes in a direction away from the adhesive layer 5. In the section view of the fine wire 64 in the short direction, the top surface flat portion 622 is present between the protrusions 623 and 623 which are present at the both ends of the top surface 62. These protrusions 623 and the top surface flat portion 622 are continuously connected to each other in the section view of the fine wire 64 in the short direction. A height of the protrusion 623 (a height from the top surface 62 to a distal end of the protrusion 623) is preferably within a range of 0.1 μm to 1.0 μm. A width of the protrusion 623 (a distance between both ends of the protrusion 623 positioned on a first virtual straight line $L_1$ extending on the top surface 62 (the top surface flat portion 622)) is preferably within a range of 0.1 μm to 1.0 μm.

An angle θ between the side surface 63 and the top surface 62 is preferably 90° or more and 170° or less ($90° \leq \theta \leq 170°$) in terms of suppressing scattering of light on the side surface 63. In the present embodiment, in one fine wire 64, an angle between one side surface 63 and the top surface 62 is substantially equal to an angle between the other side surface 63 and the top surface 62. The angle θ refers to an angle between the first virtual straight line $L_1$ and a second virtual straight line $L_2$ (described below).

When the top surface 62 does not include the protrusion 623, the top surface 62 is continuously formed through corner portions 621 and 621 between the side surfaces 63 and 63 in a section view in a short direction as illustrated in Fig. 4. In this case, the corner portions 621 and 621 preferably correspond to 90° or more and 170° or less ($90° \leq \theta \leq 170°$).

When the corner portions 621 and 621 are formed as described above, a range between the corner portions 621 and 621 corresponds to the top surface 62. In addition, when R shapes are formed at portions corresponding to the corner portions 621 and 621, respectively, a range between positions at which radii of curvatures of the R shapes correspond to minimum values or a range between central positions of the R shapes in a section view corresponds to the top surface 62.

As illustrated in Fig. 3, the side surface 63 extends between the contact surface 61 and the top surface 62. The side surface 63 is connected to the top surface 62 at one end portion 631, and connected to the contact surface 61 at the other end portion 632.

The side surfaces 63 and 63 have straight line shapes in the section view in the short direction, and are formed to be inclined such that the side surfaces 63 and 63 approaches each other as being separated from the adhesive layer 5. The fine wire 64 has a tapered shape in which a width is narrowed as being separated from the adhesive layer 5 in the section view of the fine wire 64 in the short direction. In addition, in the present embodiment, the side surfaces 63 and 63 are continuously connected to the side surfaces 521 and 521 at portions connected to a boundary surface between the contact surfaces 522 and 61 in the section view in the short direction.

The side surface 63 includes a side surface flat portion 633 in a cross section of the fine wire 64 in a width direction. The side surface flat portion 633 is a portion having a straight line shape present on the side surface 63 in the section view of the fine wire 64 in the short direction. Flatness of the side surface flat portion 633 is 0.5 $\mu$m or less. The side surface 63 of the present embodiment is a surface extending on the second virtual straight line $L_2$ passing through the both ends 631 and 632 thereof. A substantially whole side surface 63 corresponds to the side surface flat portion 633.

The shape of the side surface 63 is not particularly restricted to the above-described shape. For example, the side surface 63 may have a circular arc shape protruding outward in the section view of the fine wire 64 in the short direction. In this case, the side surface 63 is present outside the second virtual straight line $L_2$. In this way, the side surface 63 preferably has a shape which is not present inside the virtual straight line passing through the both ends thereof in the section view of the fine wire in the short direction. For example, the shape of the side surface preferably does not correspond to a circular arc shape in which the side surface is recessed inward (that is, a shape in which a hem of the fine wire widens) when the width of the fine wire gradually increases as approaching a first resin layer in the section view of the fine wire in the short direction.

Surface roughness of the contact surface 61 of the mesh-like electrode layer 6 (fine wire 64) is preferably relatively rougher than surface roughness of the top surface 62 in terms of strongly fixing the mesh-like electrode layer 6 and the adhesive layer 5. In the present embodiment, since the top surface 62 includes the top surface flat portion 622, the above-described relative relation with regard to the surface roughness (relation in which the surface roughness of the top surface 62 is relatively larger than the surface roughness of the contact surface 61) is satisfied. Specifically, it is preferable that the surface roughness Ra of the contact surface 61 is within a range of about 0.1 $\mu$m to 3.0 $\mu$m, and the surface roughness Ra of the top surface 62 is within a range of about 0.001 $\mu$m to 1.0 $\mu$m. The surface roughness Ra of the contact surface 61 is more preferably within a range of 0.1 $\mu$m to 0.5 $\mu$m, and the surface roughness Ra of the top surface 62 is more preferably within a range of 0.001 $\mu$m to 0.3 $\mu$m. In addition, a relation of the surface roughness of the top surface 62 with respect to the surface roughness of the contact surface 61 preferably corresponds to 0.01 or more and less than 1, and more preferably corresponds to 0.1 or more and less than 1. In addition, the surface roughness of the top surface 62 is preferably 1/5 or less the width (maximum width) of the fine wire 64. Such surface roughness may be measured by the JIS method (JIS B0601 (revised on March 21, 2013)). The surface roughness of the contact surface 61 or the surface roughness of the top surface 62 may be measured along a width direction of the fine wire 64 or along an extending direction of the fine wire 64.

Incidentally, as described in the JIS method (JIS B0601 (revised on March 21, 2013)), the "surface roughness Ra" herein refers to an "arithmetic average roughness Ra". This "arithmetic average roughness Ra" refers to a roughness parameter obtained by excluding a long wavelength component (waviness component) from a profile curve. The waviness component is separated from the profile curve based on a measurement condition (for example, dimensions of an object, etc.) necessary to obtain a form.

In the present embodiment, the side surface 63 includes the side surface flat portion 633. For this reason, similarly to the top surface 62, the surface roughness of the contact surface 61 is relatively larger than the surface roughness of the side surface 63. While the surface roughness Ra of the contact surface 61 is within a range of 0.1 $\mu$m to 3 $\mu$m, the surface roughness Ra of the side surface 63 is preferably within a range of 0.001 $\mu$m to 1.0 $\mu$m, and more preferably within a range of 0.001 $\mu$m to 0.3 $\mu$m. The surface roughness of the side surface 63 may be measured along the width direction of the fine wire 64 or along the extending direction of the fine wire 64.

When a relative relation between the surface roughness of the contact surface 61 and the surface roughness of another surface except for the contact surface 61 (the top surface 62 and the side surface 63) satisfies the above-described relation, a diffuse reflectance on a side of the other surface except for the contact surface 61 is smaller than a diffuse reflectance on a side of the contact surface 61. In this case, a ratio of the diffuse reflectance on the side of the other surface except for the contact surface 61 to the diffuse reflectance on the side of the contact surface 61 is preferably 0.1 or more and less than 1, and more preferably 0.3 or more and less than 1.

A description will be given of an example of a shape of the fine wire having the above-described relative relation between the surface roughness of the contact surface and the surface roughness of the other surface except for the contact surface with reference to Fig. 5. On a contact surface 61B of a mesh-like electrode layer 6B including conductive particles M and a binder resin B, some of the conductive particles M protrude from the binder resin B in a section view of a fine wire 64B in a short direction. In this way, the contact surface 61B has a concavo-convex shape. Meanwhile, on a top surface 62B and a side surface 63B, the binder resin B penetrates between conductive particles M in the section view of the fine wire 64B in the short direction. The top surface 62B and the side surface 63B are dotted with slightly exposed portions of the conductive particles M. However, the binder resin B covers the conductive particles M. In this way, a top surface flat portion 622B having a straight line shape is included in the top surface 62B, and a side surface flat portion 633B having a straight line shape is included in the side surface 63B. In this case, surface roughness of the contact surface 61B is relatively larger than surface roughness of the top surface 62B and relatively larger than surface roughness of the side surface 63B. When the binder resin B covers the conductive particles M on the side surface 63B, electric insulation between adjacent fine wires 64B is improved, and occurrence of migration is suppressed.

The "contact surface 61" in the present embodiment corresponds to an example of a "first surface" in the invention, the "top surface 62" in the present embodiment corresponds to an example of a "second surface" in the invention, and the "side surface 63" in the present embodiment corresponds to an example of a "side surface" in the invention.

The fine wire 64 is arranged in the mesh-like electrode layer 6 of the present embodiment as described below. In more detail, as illustrated in Fig. 2, the first fine wire 64a extends in a straight line shape along a direction inclined by +45° with respect to the X direction (hereinafter simply referred to as a "first direction"). Further, first fine wires 64a is arranged at an equal pitch $P_1$ in a direction substantially orthogonal to the first direction (hereinafter simply referred to as a "second direction"). On the other hand, the second fine wire 64b extends in a straight line shape along the second direction, and second fine wires 64b is arranged at an equal pitch $P_2$ in the first direction. In addition, when the first and second fine wires 64a and 64b are orthogonal to each other, the mesh-like electrode layer 6 in which a rectangular unit mesh is repeated is formed.

A configuration of the mesh-like electrode layer 6 is not particularly restricted to the above-described configuration. For example, in the present embodiment, the pitch $P_1$ of the first fine wires 64a is substantially equal to the pitch $P_2$ of the second fine wires 64b ($P_1 = P_2$). However, the invention is not particularly restricted thereto, and the pitch $P_1$ of the first fine wires 64a may be different from the pitch $P_2$ of the second fine wires 64b ($P_1 \neq P_2$).

In addition, in the present embodiment, the first direction corresponding to an extending direction of the first fine wire 64a is set to a direction inclined by +45° with respect to the X direction, and the second direction corresponding to an extending direction of the second fine wire 64b is set to a direction substantially orthogonal to the first direction. However, the extending directions of the first and second directions (that is, an angle of the first direction with respect to an X axis and an angle of the second direction with respect to the X axis) may be arbitrarily set.

In addition, an external shape of a unit mesh of the mesh-like electrode layer 6 may correspond to a geometric form. In more detail, the shape of the unit mesh of the mesh-like electrode layer 6 may correspond to a triangle such as a regular triangle, an isosceles triangle, a right triangle, etc., and may correspond to a tetragon such as a rectangle, a square, a rhombus, a parallelogram, a trapezoid, etc. Alternatively, the shape of the unit mesh may correspond to an n-polygon such as a hexagon, an octagon, a dodecagon, an icosagon, etc., a circle, an ellipse, a star, etc.

In this way, as the mesh-like electrode layer 6, a geometric form obtained by repeating various figure units may be used as the shape of the unit mesh of the mesh-like electrode layer 6. In addition, in the present embodiment, the fine wire 64 has the straight line shape. However, the invention is not restricted thereto. For example, the fine wire 64 may correspond to a curved shape, a horseshoe shape, a zigzag line shape, etc.

In the present embodiment, a width of the fine wire 64 is preferably within a range of 50 nm to 1,000 $\mu$m, more preferably within a range of 500 nm to 150 $\mu$m, even more preferably within a range of 1 $\mu$m to 10 $\mu$m, and further even more preferably within a range of 1 $\mu$m to 5 $\mu$m. In addition, a thickness (height) of the fine wire 64 is preferably within a range of 50 nm to 3,000 $\mu$m, more preferably within a range of 500 nm to 450 $\mu$m, and even more preferably within a range of 500 nm to 10 $\mu$m.

As illustrated in Fig. 6, the mesh-like electrode layer 6 of the present embodiment includes intersection regions T1 and non-intersection regions T2 in a planar view. Respective intersection regions T1 are separated from each other. In more detail, one non-intersection region T2 is interposed between adjacent intersection regions T1.

The intersection region T1 is a region in which the first and second fine wires 64a and 64b intersect each other. Specifically, in a planar view, the intersection region T1 is a squire region enclosed and demarcated by an external shape of the first fine wire 64a having the straight line shape (specifically, a virtual line extending along the external shape of the first fine wire 64a) and an external shape of the second fine wire 64b having the straight line shape (specifically, a virtual line extending along the external shape of the second fine wire 64b). Meanwhile, the non-intersection region T2 is a region except for the above-described intersection region T1 in the mesh-like electrode layer 6. In the present embodiment, the top surface 62 and the side surface 63 which may be visually recognized in the planar view are included in the intersection region T1 or the non-intersection region T2.

In the present embodiment, the fine wire 64 is formed to have a uniform width, and thus a width of the intersection region T1 is substantially equal to a width of the non-intersection region T2. The invention is not particularly restricted to the above description, and the fine wire 64 may be formed such that the width of the fine wire 64 gradually increases from the non-intersection region T2 toward the intersection region T1. In other words, the width of the fine wire 64 in the intersection region T1 may be relatively larger than the width of the fine wire 64 in the non-intersection region T2.

In the mesh-like electrode layer 6 of the present embodiment, as illustrated in Fig. 7, a depression 65 recessed toward the adhesive layer 5 (that is, in the -Z direction) is formed in each of the intersection regions T1. In this depression 65, the thickness (height) of the mesh-like electrode layer 6 in an intersection region T1 in which the depression 65 is present is relatively smaller than the thickness (height) of the mesh-like electrode layer 6 in an adjacent non-intersection region T2.

The depression 65 of the present embodiment is provided at a position substantially matching a center C of the intersection region T1. In the planar view, the center C of the intersection region T1 of the present embodiment corresponds to an intersection point of a central line L1 of the first fine wire 64a and a central line L2 of the second fine wire 64b (see Fig. 6).

In the present embodiment, depressions 65 formed in the respective intersection regions T1 have substantial the same height. The invention is not particularly restricted thereto, and the respective depressions 65 may have different heights.

Incidentally, it is preferably that Formula (2) below is satisfied in the mesh-like electrode layer 6 of the present embodiment.

$$H_1 \times 1/2 \leq H_2 < H_1 \ \dots \ (2)$$

However, in the above Formula (2), $H_1$ denotes an average height of the mesh-like electrode layer 6 in the non-intersection region T2, and $H_2$ denotes an average height of the mesh-like electrode layer 6 in the depression 65.

When the above Formula (2) is satisfied, a surface area on the top surface 62 is reliably ensured, an adhesive property is improved between the mesh-like electrode layer 6 and the resin layer 8 stacked on the mesh-like electrode layer 6, and occurrence of separation is suppressed.

In the present embodiment, one depression 65 is formed in accordance with every intersection region T1. However, the invention is not particularly restricted thereto. For example, both an intersection region T1 in which the depression 65 is formed and an intersection region T1 in which the depression 65 is not formed may be present in the mesh-like electrode layer 6. Depressions may be formed in accordance with one intersection region T1.

An external shape of the depression 65 of the present embodiment is set to a circular arc shape in a section view in a longitudinal direction. In more detail, the thickness (height) of the mesh-like electrode layer 6 decreases smoothly and continuously from the top surface 62 in an adjacent non-intersection region T2 to the depression 65. In this case, in the intersection region T1, the thickness (height) of the mesh-like electrode layer 6 gradually decreases toward the depression 65. The external shape of the depression 65 is not particularly restricted to the above-described shape, and a portion of the depression 65 may correspond to an acute angle, a right angle, or an obtuse angle.

As illustrated in Fig. 8, the protrusion 623 of the present embodiment is formed at the both ends of the top surface 62 continuously along the extending direction of the fine wire 64. In a portion in which the first fine wire 64a and the second fine wire 64b intersect each other, the protrusion 623 included in the first fine wire 64a is continuously connected to the protrusion 623 included in the second fine wire 64b. The depression 65 is formed around a center of the portion in which the first fine wire 64a and the second fine wire 64b intersect each other.

The depression 65 is continuously connected to the top surface flat portion 622 in a cross section illustrated in Fig. 9 in the portion in which the first fine wire 64a and the second fine wire 64b intersect each other. The top surface flat portion 622 is continuously connected to the protrusion 623 in the cross section illustrated in Fig. 9 in the portion in which the first fine wire 64a and the second fine wire 64b intersect each other. The depression 65 and the protrusion 623 are continuously connected through the top surface flat portion 622 as illustrated in Fig. 9 in the portion in which the first fine wire 64a and the second fine wire 64b intersect each other.

In the present embodiment, an average height of the mesh-like electrode layer 6 in the non-intersection region T2 is obtained as below using a scanning electron microscope (SEM) or a transmission electron microscope (TEM). In more detail, the height of the mesh-like electrode layer 6 in the non-intersection region T2 is measured at positions in the section view in the longitudinal direction using the SEM or the TEM, and an arithmetic mean value of measured values thereof is set to the average height of the mesh-like electrode layer 6 in the non-intersection region T2. In this case, the height of the mesh-like electrode layer 6 in the non-intersection region T2 is measured at least at ten positions or more. In the present embodiment, a "cross section in the longitudinal direction" refers to a cross section in a segment substantially matching a central line L of the fine wire 64 in the planar view.

In addition, similarly, an average height of the mesh-like electrode layer 6 in the depression 65 is obtained as below. In more detail, the height of the mesh-like electrode layer 6 in the depression 65 is measured at positions in the section view in the longitudinal direction using the SEM or the TEM, and an arithmetic mean value of measured values thereof is set to an the average height of the mesh-like electrode layer 6 in the depression 65. In this case, the height of the mesh-like electrode layer 6 in the depression 65 is measured at least at ten positions or more.

The resin layer 8 is formed by being stacked on the mesh-like electrode layer 6. In the wiring body 4 of the present embodiment, as a result, the mesh-like electrode layer 6 is interposed between the adhesive layer 5 and the resin layer 8. In a region in which the mesh-like electrode layer 6 is not present, the resin layer 8 is directly stacked on the adhesive layer 5 (the smooth portion 51).

The resin layer 8 of the present embodiment is an insulating layer that has a function of ensuring insulation between the mesh-like electrode layer 6 and the mesh-like electrode layer 9 formed on the mesh-like electrode layer 6 through the resin layer 8. Use of the resin layer 8 is not particularly restricted to the above description. For example, the resin layer 8 may be used as an overcoat layer having a function of protecting the mesh-like electrode layer 6 from the outside.

Examples of a material contained in the resin layer 8 may include a UV-curing resin, a thermosetting resin, a thermoplastic resin, etc. such as epoxy resin, acrylic resin, polyester resin, urethane resin, vinyl resin, silicone resin, phenol resin, polyimide resin, etc.

In the present embodiment, a contact area between the mesh-like electrode layer 6 and the resin layer 8 increases when the depression 65 is formed in the mesh-like electrode layer 6. In this way, an adhesive property between the mesh-like electrode layer 6 and the resin layer 8 is improved, and separation between the mesh-like electrode layer 6 and the resin layer 8 is suppressed. The "resin layer 8" in the present embodiment corresponds to an example of a "second resin layer" in the invention.

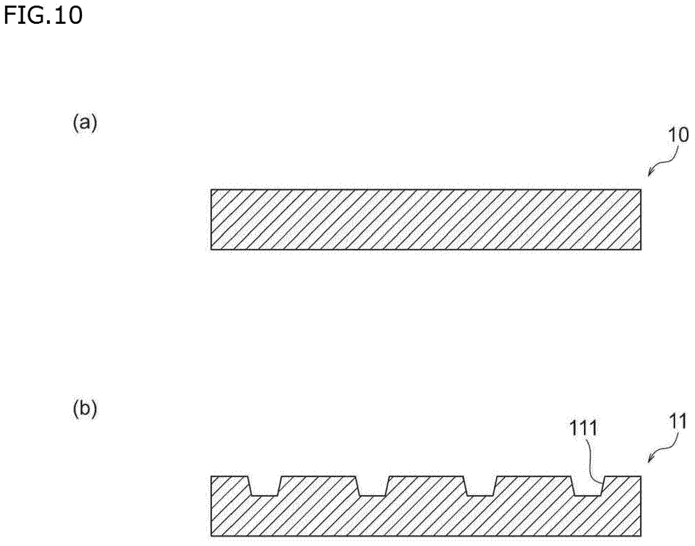

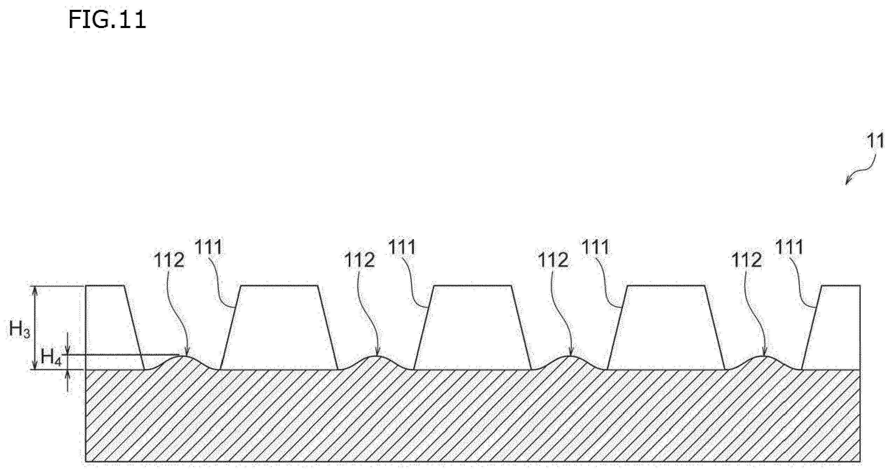

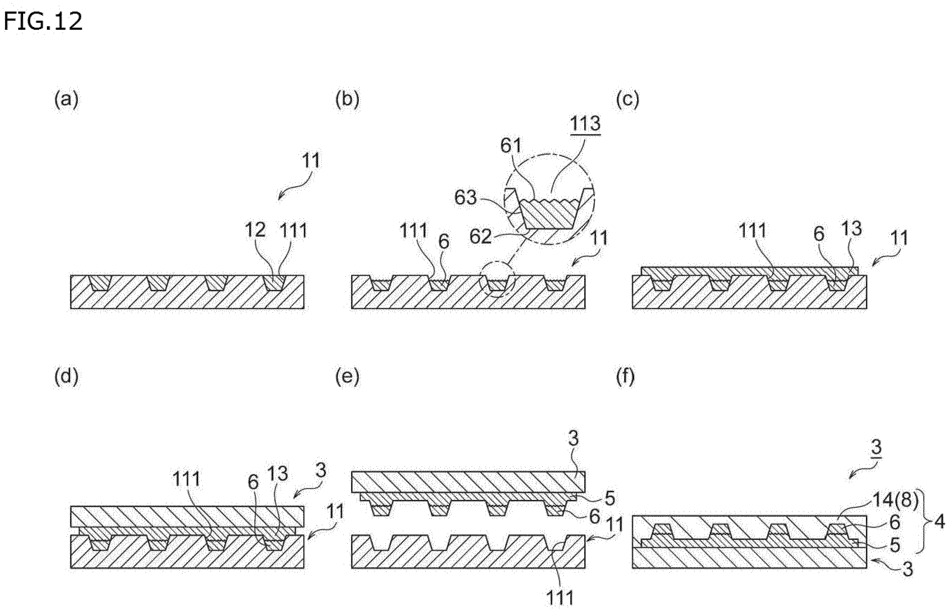

Next, a description will be given of a method of manufacturing the wiring board 2 in the present embodiment. Fig. 10(a) and Fig. 10(b) are diagrams illustrating a method of manufacturing the wiring board according to an embodiment of the invention, and cross-sectional views for description of a method of preparing intaglio. Fig. 11 is a diagram illustrating the intaglio according to an embodiment of the invention, and a cross-sectional view of a state in which a convex portion of the intaglio is included, and Fig. 12(a) to Fig. 12(f) are diagrams illustrating the method of manufacturing the wiring board according to the embodiment of the invention.

In the present embodiment, first, a detailed description will be given of a method of preparing intaglio 11 used to manufacture the wiring board 2 with reference to Fig. 10(a), Fig. 10(b), and Fig. 11. Subsequently, a detailed description will be given of a method of manufacturing the wiring board 2 with reference to Fig. 12 (a) to Fig. 12(f).

In the method of preparing intaglio 11, first, a plate 10 is prepared as illustrated in Fig. 10(a). For example, both main surfaces (at least a surface on which a groove 111 (described below) is formed) of the plate 10 are preferably subjected to mirror finishing using chemical mechanical polishing (CMP). Examples of a material contained in the plate 10 may include glass of nickel, silicon, silicon dioxide, etc., ceramic, organosilica, glassy carbon, a thermoplastic resin, a light curing resin, etc.

Subsequently, as illustrated in Fig. 10(b), the groove 111 is formed on one main surface of the plate 10 as below. Herein, for example, a description will be given of a case in which the plate 10 made of nickel is used. However, in this case, photoresist formed on the one main surface of the plate 10 is selectively exposed to light such that photoresist in a region corresponding to the groove 111 is soluble, thereby forming a light exposure pattern corresponding to the groove 111. Then, a developing solution, etc. is supplied to the plate 10 to remove the light exposure pattern of the photoresist formed on the plate 10. Thereafter, a known etching process is performed on the plate 10 to form the groove 111. Finally, the photoresist is removed. In this way, the intaglio 11 may be obtained.

As a method of selectively exposing the photoresist to light, a resist layer (photomask) may be formed on the plate 10, and then the plate 10 may be exposed to light (surface light exposure). Alternatively, the photoresist may be irradiated with laser light, thereby being selectively exposed to light (scanning light exposure). A light source used at the time of light exposure is not particularly restricted. However, for example, examples of the light source may include light such as visible light, ultraviolet light, etc. or radioactive rays such as an X-ray, etc.

The groove 111 is upwardly open to the outside, and an external shape thereof is a shape corresponding to the mesh-like electrode layer 6 (the fine wire 64). In the present embodiment, a width of the groove 111 is preferably within a range of 50 nm to 1,000 $\mu$m, more preferably within a range of 500 nm to 150 $\mu$m, even more preferably within a range of 1 $\mu$m to 10 $\mu$m, and further even more preferably within a range of 1 $\mu$m to 5 $\mu$m. A depth of the groove 111 is preferably within a range of 50 nm to 3,000 $\mu$m, more preferably within a range of 500 nm to 450 $\mu$m, and even more preferably within a range of 500 nm to 10 $\mu$m.

Herein, in the plate 10 of the present embodiment, as illustrated in Fig. 11, a convex portion 112 is formed inside the groove 111 together with forming the groove 111. The convex portion 112 is formed in a portion corresponding to the intersection region T1 of the mesh-like electrode layer 6 in the plate 10, and protrudes toward a side at which a thickness (height) of the plate 10 is increased when compared to a bottom surface of the groove 111. An external shape of the convex portion 112 is set to a shape corresponding to the depression 65 of the mesh-like conductor 5.

Referring to the convex portion 112, Formula (3) below is preferably satisfied in terms of suppressing generation of separation between the mesh-like electrode layer 6 and the resin layer 8.

$$H_3 \times 1/2 \geq H_4 \quad ... \quad (3)$$

However, in the above Formula (3), $H_3$ denotes an average height of the groove 111, and $H_4$ denotes an average height of the convex portion 112.

In the present embodiment, the groove 111 and the convex portion 112 are formed in the same process. In this case, an exposure amount in a portion corresponding to the intersection region T1 in the photoresist formed on the plate 10 is set to be relatively smaller than an exposure amount in a portion other than the portion corresponding to the intersection region T1 in the photoresist formed on the plate 10. In this way, an etching residue is generated in the portion corresponding to the intersection region T1 in the plate 10, and the convex portion 112 is formed.

A method of forming the groove 111 and the convex portion 112 is not particularly restricted to the above-described method. For example, when the groove and the convex portion are formed by a method other than the above-described photoetching process, the groove and the convex portion may be formed in the same process by setting a degree of processing with respect to the plate in the portion corresponding to the intersection region of the mesh-like conductor layer in the plate to be smaller than a degree of processing with respect to the plate in another region.

Alternatively, the groove 111 and the convex portion 112 may be formed by different processes. For example, after forming the groove on the plate by employing a known method, the convex portion may be formed in a portion corresponding to the intersection region of the mesh-like electrode layer inside the groove using chemical vapor deposition (CVD), etc.

Next, a detailed description will be given of the method of manufacturing the wiring board 2 with reference to Fig. 12(a) to Fig. 12(f).

First, as illustrated in Fig. 12(a), the intaglio 11 prepared as described above is filled with an electrically conductive material 12. A release layer is preferably formed on a surface of the intaglio 11 including the groove 111 before filling the intaglio 11 with the electrically conductive material 12 to improve a release property. Examples of a material included in the release layer may include a graphite-based material, a silicone-based material, a fluorine-based material, a ceramic-based material, an aluminum-based material, etc.

The above-described conductive paste is used as the electrically conductive material 12. Examples of a method of filling the groove 111 of the intaglio 11 with the electrically conductive material 12 may include a dispensing method, an ink-jet method, screen printing, etc. Otherwise, the examples may include a method in which after coating using a slit coating method, a bar coating method, a blade coating method, a dip coating method, a spray coating method, or a spin coating method, the electrically conductive material 12 coated in a portion other than the depression is removed by wiping, scraping, sucking, sticking, washing, or blowing. A composition, etc. of the electrically conductive material 12 may be appropriately used properly according to a shape of the intaglio, etc.

Subsequently, as illustrated in Fig. 12(b), the mesh-like electrode layer 6 is formed by heating the electrically conductive material 12 filling the groove 111 of the intaglio 11. In this instance, the fine wires 64a and 54b of the mesh-like electrode layer 6 are formed in accordance with the groove 111 of the intaglio 11. In addition, the depression 65 is formed in the mesh-like electrode layer 6 in accordance with the convex portion 112 formed in the intaglio 11. A condition for heating the electrically conductive material 12 may be appropriately set depending on the composition of the electrically conductive material 12, etc.

In addition, the electrically conductive material 12 contracts in volume through a heating process. In this instance, an external surface of the electrically conductive material 12 except for an upper surface is formed in a shape along an external shape of the groove 111 or an external shape of the convex portion 112. In addition, when the electrically conductive material 12 contracts in volume, a void 113 connected to an external space of the groove 111 is formed on the mesh-like electrode layer 6 inside the groove 111 of the intaglio 11. A method of processing the electrically conductive material 12 is not restricted to heating. The electrically conductive material 12 may be irradiated with an energy line such as an infrared ray, an ultraviolet ray, laser light, etc. or may only be dried.

In the present embodiment, the electrically conductive material 12 is heated and the mesh-like electrode layer 6 is baked while the intaglio 11 is filled with the electrically conductive material 12, and thus bleeding of the mesh-like electrode layer 6 is suppressed, and generation of moire may be inhibited. In this way, visibility is improved in the touch sensor using the wiring body 4 (the wiring board 2).

Subsequently, as illustrated in Fig. 12(c), a resin material 13 for forming the adhesive layer 5 is applied onto the intaglio 11. Examples of the resin material 13 may include the same material as the above-mentioned material included in the adhesive layer 5. Examples of a method of applying the resin material 13 onto the intaglio 11 may include screen printing, a spray coating method, a bar coating method, a dip method, an ink-jet method, etc. Through this application, the resin material 13 penetrates into the groove 111 to come into contact with the contact surface 61 of the mesh-like electrode layer 6.

Subsequently, as illustrated in Fig. 12(d), the substrate 3 is disposed from above the resin material 13 applied onto the intaglio 11.

This disposition is preferably performed in a vacuum in order to inhibit a bubble from penetrating between the resin material 13 and the substrate 3. Subsequently, the resin material 13 is hardened. In this way, the adhesive layer 5 is formed, and the substrate 3 and the mesh-like electrode layer 6 are bonded and fixed to each other through the adhesive layer 5. In this instance, when the resin material 13 filling the void 113 is hardened, the support portion 52 of the adhesive layer 5 is formed.

In the present embodiment, the substrate 3 is stacked after the resin material 13 is applied onto the intaglio 11. However, the invention is not restricted thereto. For example, the substrate 3 may be stacked on the intaglio 11 through the resin material 13 by disposing, on the intaglio 11, a layer obtained by applying the resin material 13 to the main surface (surface facing the intaglio 11) of the substrate 3 in advance.

Subsequently, the substrate 3, the adhesive layer 5, and the mesh-like electrode layer 6 are released from a mold (see Fig. 12(e)). In this instance, as in the present embodiment, a mold release operation may be facilitated by forming the groove 111 of the intaglio 11 in a tapered shape.

Subsequently, as illustrated in Fig. 12(f), the resin material 14 included in the resin layer 8 is applied to cover the mesh-like electrode layer 6. Examples of such a resin material 71 may include the same material as the above-mentioned material included in the resin layer 8.

Viscosity of the material included in the resin layer 8 is preferably within a range of 1 mPa·s to 10,000 mPa·s in terms of ensuring sufficient fluidity at the time of application. In addition, storage elastic modulus of resin after hardening is preferably $10^6$ Pa or more and $10^9$ Pa or less in terms of durability of the mesh-like electrode layer 6. Examples of a method of applying the resin material 14 may include screen printing, a spray coating method, a bar coating method, a dip method, an ink-jet method, etc.

In addition, the wiring board 2 including the wiring body 4 of the present embodiment may be obtained when the resin material 14 hardens.

Although not particularly illustrated, the touch sensor 1 including the wiring board 2 may be obtained by forming the mesh-like electrode layer 9 on the wiring board 2 obtained after the above-described process is executed such that the mesh-like electrode layer 9 faces the mesh-like electrode layer 6.

Examples of a method of forming the mesh-like electrode layer 9 may include the same method as a method of forming the mesh-like electrode layer 6. The method of forming the mesh-like electrode layer 9 is not particularly restricted to the above-described method. For example, after hardening the resin layer 8, the mesh-like electrode layer 9 may be formed by printing an electrically conductive material on the resin layer 8 using screen printing, gravure offset printing, ink jet printing, etc. Alternatively, the mesh-like electrode layer 9 may be formed by patterning a metal layer stacked on the resin layer 8 in a mesh shape. Alternatively, the mesh-like electrode layer 9 may be formed on the resin layer 8 using a sputtering method, a vacuum evaporation method, a CVD method, electroless plating, electroplating, or a combination of these methods.

The wiring body 4, the wiring board 2, and the touch sensor 1 in the present embodiment accomplish the following effects.

In the present embodiment, a contact area between the mesh-like electrode layer 6 and the resin layer 8 covering the mesh-like electrode layer 6 increases due to the depression 65 formed in the intersection region T1. In this way, an adhesive property between the mesh-like electrode layer 6 and the resin layer 8 is improved, and separation between the mesh-like electrode layer 6 and the resin layer 8 is suppressed.

In addition, in the mesh-like electrode layer 6 of the present embodiment, it is possible to more reliably ensure the contact area between the mesh-like electrode layer 6 and the resin layer 8 covering the mesh-like electrode layer 6 when the above Formula (2) is satisfied. In this way, the adhesive property between the mesh-like electrode layer 6 and the resin layer 8 is more reliably ensured, and separation between the mesh-like electrode layer 6 and the resin layer 8 is further suppressed.

In addition, in the present embodiment, the side surfaces 63 and 63 have straight line shapes in the section view in the short direction, and are formed to be inclined such that the side surfaces 63 and 63 approach each other as being separated from the contact surface 61. In this way, the mold release operation may be facilitated when the substrate 3, the adhesive layer 5, and the mesh-like electrode layer 6 are released from the intaglio 11.

In addition, in the present embodiment, the top surface 62 includes the protrusion 623 protruding in a direction away from the first resin layer 5. For this reason, the protrusion 623 penetrates into the resin layer 8, and separation between the mesh-like electrode layer 6 and the resin layer 8 may be suppressed. In particular, stress is most easily concentrated on the end portion of the top surface 62 at which the extending direction of the surface rapidly changes in the cross section of the fine wire 64 in the short direction, and thus the portion easily becomes an origin of separation. In the wiring body 4 of the present embodiment, the protrusion 623 is included in the end portion of the top surface 62, and thus separation between the mesh-like electrode layer 6 and the resin layer 8 may be more reliably suppressed. In addition, the protrusion included in the first fine wire 64a and the protrusion included in the second fine wire 64b are continuously connected to each other in a portion in which the first fine wire 64a and the second fine wire 64b intersect each other. For this reason, the protrusion 623 penetrates into the resin layer 8 in the portion in which the first fine wire 64a and the second fine wire 64b intersect each other and separation between the mesh-like electrode layer 6 and the resin layer 8 easily occurs. Thus, separation between the mesh-like electrode layer 6 and the resin layer 8 may be further suppressed.

In the present embodiment, there is a concern that visibility of the wiring body may deteriorate when the protrusion 623 is formed. However, originally, scattering of light easily occurs around the end portion at which the extending direction of the surface rapidly changes. For this reason, even when the protrusion 623 is provided, a degree of scattering of light on the top surface 62 is rarely influenced.

In addition, in the wiring body 4 of the present embodiment, a focus is on a relative relation between surface roughness (that is, a roughness parameter obtained by excluding a wavelength component) of the contact surface 62 of the fine wire 64 and surface roughness of another surface except for the contact surface 61 (a surface including the top surface 62 and the side surface 63) in the section view of the fine wire 64 in the short direction. Further, the surface roughness Ra of the contact surface 61 is set to be relatively rougher than the surface roughness Ra of the other surface. For this reason, it is possible to suppress diffused reflection of light entering from the outside while strongly bonding the adhesive layer 5 and the mesh-like electrode layer 6 together. In particular, when the width of the fine wire 64 is within a range of 1 $\mu$m to 5 $\mu$m, and when a relative relation between the surface roughness of the contact surface 61 and the surface roughness of the other surface satisfies the above-described relation, it is possible to noticeably accomplish the effect that diffused reflection of light entering from the outside may be suppressed while strongly bonding the adhesive layer 5 and the mesh-like electrode layer 6 together.

In addition, in the present embodiment, the side surface 63 extends to substantially match the second virtual straight line $L_2$ passing through the end portions 631 and 632. In this case, a portion of the side surface does not have a shape which is not present inside the virtual straight line passing through the both ends of the side surface in the cross section of the fine wire 64 in the width direction, and thus diffused reflection of light entering from the outside of the wiring body 4 is suppressed. In this way, visibility of the wiring body 4 may be further improved.

In addition, in the present embodiment, when the surface roughness Ra of the contact surface 61 is set to be relatively rougher than the surface roughness Ra of another surface except for the contact surface 61 (the surface including the top surface 62 and the side surface 63), a diffuse reflectance on the other surface side is relatively smaller than a diffuse reflectance on the contact surface 61 side. Herein, when the diffuse reflectance of the wiring body 4 is small, it is possible to inhibit the fine wire 64 from appearing white, and to suppress a decrease in contract in a region in which the conductor pattern 41 may be visually recognized. In this way, it is possible to further improve visibility of the wiring body 4 of the present embodiment.

The above-described embodiment has been described to facilitate understanding of the invention, and has not been described to restrict the invention. Therefore, each element disclosed in the above embodiment is intended to include all changes of design or equivalents falling within a technical scope of the invention.

For example, the touch sensor of the present embodiment is a touch panel sensor corresponding to a projection-type capacitive sensing method having two electrodes. However, the invention is not restricted thereto. The invention is applicable to a touch panel sensor corresponding to a surface-type (capacitive coupling-type) capacitive sensing method having one electrode.

In addition, for example, in the present embodiment, the metal material or the carbon-based material is used as the electrically conductive material (conductive particles) included in the mesh-like electrode layers 6 and 9. However, the invention is not particularly restricted thereto, and the metal material mixed with the carbon-based material may be used. In this case, for example, when the fine wire 64 is described as an example, the carbon-based material may be disposed on the top surface 62 side of the fine wire 64, and the metal material may be disposed on the contact surface 61 side. Alternatively, reversely, the metal material may be disposed on the top surface 62 side of the fine wire 64, and the carbon-based material may be disposed on the contact surface 61 side.

In addition, it is possible to form an adhesive layer obtained by omitting a portion other than a portion formed on a lower surface side of the mesh-like electrode layer 6 in the smooth portion 51 of the adhesive layer 5. For example, such an adhesive layer may be formed by forming an adhesive layer on a whole main surface of a substrate to manufacture a wiring board, and then removing the adhesive layer except for a portion around a mesh-like conductor layer using etching, etc.

In this case, it is possible to improve optical transparency of the whole wiring board, and to improve visibility when the wiring board is used for the touch panel, etc. Further, when a colored material is used as the material included in the adhesive layer, it is possible to suppress diffused reflection of light in the mesh-like conductor layer, and to further improve visibility when the wiring board is used for the touch panel, etc.

In addition, for example, the substrate 3 may be omitted from the wiring board 2. In this case, for example, the wiring body or the wiring board may be configured in a mode in which a release sheet is provided on a lower surface of the adhesive layer 5, and the wiring body or the wiring board is mounted by peeling off the release sheet and bonding the wiring body or the wiring board to a mounting object (a film, surface glass, a polarizing plate, a display, etc.) at the time of amounting. In this mode, the "adhesive layer 5" corresponds to an example of a "first resin layer" of the invention, and the "mounting object" corresponds to an example of a "support" of the invention. Alternatively, the wiring body or the wiring board may be configured in a mode in which the wiring body or the wiring board is bonded and mounted on the above-described mounting object through the resin layer 8 covering the mesh-like conductor layer. In this mode, the "resin layer 8" corresponds to an example of "second and third resin layers" of the invention, and the "mounting object" corresponds to an example of a "support" of the invention.

In addition, the smooth portion 51 of the adhesive layer 5 may be used as the support. In this case, the "support portion 52" of the adhesive layer 5 corresponds to an example of a "first resin layer" of the invention, and the smooth portion 51 of the adhesive layer 5 corresponds to an example of a "support" of the invention.

In addition, in the present embodiment, the conductor layer of the invention is used as the mesh-like electrode layer 6. However, the invention is not particularly restricted thereto. That is, the conductor layer of the invention may be applied to a lead-out wire or a terminal included in the wiring board.

In the above-described embodiment, a description has been given on the assumption that the wiring body or the wiring board is used for the touch sensor of the touch panel, etc. However, use of the wiring body or the wiring board is not particularly restricted thereto. For example, the wiring body may be used as a heater by electrifying the wiring body to generate heat using resistance heating, etc. In this case, a carbon-based material having relatively high electrical resistivity is preferably used as conductive particles. Alternatively, the wiring body may be used as an electromagnetic shield by grounding a part of the conductor pattern. Alternatively, the wiring body may be used as an antenna.

EXPLANATIONS OF LETTERS OR NUMERALS

1... touch sensor
2... wiring board

   3... substrate

      31... main surface

   4... wiring body

      5... adhesive layer

         51... smooth portion

         511... main surface

      52... support portion

         521... side surface
         522... contact surface

   6... mesh-like electrode layer

      61... contact surface
      62... top surface

         621... corner portion
         622... top surface flat portion
         623... protrusion

      63... side surface

         631, 632... end portion
         633... side surface flat portion

      64... fine wire

         64a... first fine wire

            L1... central line

         64b... second fine wire

            L2... central line

      65... depression
      T1... intersection region
      T2... non-intersection region

   8... resin layer
   9... mesh-like electrode layer

10... plate
11... intaglio

      111... groove
      112... convex portion
      113... void

12... electrically conductive material
13, 14... resin material

## Claims

1.  A wiring body comprising:

    a first resin layer; and
    a conductor layer having a shape of a mesh formed by fine wires intersecting each other, and formed on the first resin layer, wherein the conductor layer includes:

an intersection region intersecting the fine wires each other; and
a non-intersection region corresponding to a region except for the intersection region, and

the conductor layer has a depression recessed toward the first resin layer in the intersection region.

2. The wiring body according to claim 1, wherein the following Formula (1) is satisfied:

$$H_1 \times 1/2 \leq H_2 < H_1 \ ... \ (1)$$

in the Formula (1), $H_1$ denotes an average height of the conductor layer in the non-intersection region, and $H_2$ denotes an average height of the conductor layer in the depression.

3. The wiring body according to claim 1 or 2, wherein the fine wires include:

a first surface coming into contact with the first resin layer; and
a second surface corresponding to a surface on an opposite side from the first surface, and

the second surface includes a flat portion in the non-intersection region.

4. The wiring body according to claim 3, wherein the second surface includes a protrusion protruding in a direction away from the first resin layer and provided to at least one of both end portions of the second surface in a cross section of the fine wires in a short direction, and
the protrusion included in one of the fine wires intersecting each other and the protrusion included in another one of the fine wires intersecting each other are continuously connected to each other in a portion in which the fine wires intersect each other.

5. The wiring body according to any one of claims 1 to 4, wherein
a height of the conductor layer gradually decreases toward the depression in the intersection region.

6. The wiring body according to any one of claims 1 to 5, wherein
an external shape of the fine wires in a cross section in a short direction includes two straight line-shaped side surfaces inclined such that the side surfaces approach each other as being separated from the first resin layer.

7. The wiring body according to any one of claims 1 to 6, further comprising
a second resin layer covering the conductor layer, wherein the conductor layer is interposed between the first and second resin layers.

8. A wiring board comprising:

the wiring body according to any one of claims 1 to 7; and
a support that supports the wiring body.

9. The wiring board according to claim 8, further comprising
a third resin layer interposed between the wiring body and the support.

10. A touch sensor comprising
the wiring board according to claim 8 or 9.

FIG. 1

EP 3 197 250 A1

FIG. 2

FIG. 3

EP 3 197 250 A1

EP 3 197 250 A1

FIG. 4

FIG. 5

FIG. 6

EP 3 197 250 A1

FIG. 7

FIG. 8

FIG. 9

EP 3 197 250 A1

FIG.10

(a)

(b)

FIG.11

FIG.12

## INTERNATIONAL SEARCH REPORT

| International application No. |
| --- |
| PCT/JP2016/063384 |

**A. CLASSIFICATION OF SUBJECT MATTER**

*H05K3/20*(2006.01)i, *G06F3/041*(2006.01)i, *G06F3/044*(2006.01)i, *H05K9/00* (2006.01)i

According to International Patent Classification (IPC) or to both national classification and IPC

**B. FIELDS SEARCHED**

Minimum documentation searched (classification system followed by classification symbols)
H05K1/00-3/46, H05K9/00, G06F3/041-3/047, H01B5/00-5/16

Documentation searched other than minimum documentation to the extent that such documents are included in the fields searched
| Jitsuyo Shinan Koho | 1922–1996 | Jitsuyo Shinan Toroku Koho | 1996–2016 |
| Kokai Jitsuyo Shinan Koho | 1971–2016 | Toroku Jitsuyo Shinan Koho | 1994–2016 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| P,X<br>P,A | WO 2015/199201 A1 (Konica Minolta, Inc.),<br>30 December 2015 (30.12.2015),<br>paragraphs [0136] to [0156], [0185], [0186];<br>fig. 8, 9<br>(Family: none) | 1,3,4,5,7-10<br>2,6 |
| A | JP 2010-147860 A (Hitachi Chemical Co., Ltd.),<br>01 July 2010 (01.07.2010),<br>fig. 6 to 16, 19, 20; paragraphs [0012] to<br>[0014], [0020] to [0054], [0087]<br>(Family: none) | 1-10 |
| A | JP 2008-283042 A (Toppan Printing Co., Ltd.),<br>20 November 2008 (20.11.2008),<br>fig. 16, 19<br>(Family: none) | 1-10 |

☒ Further documents are listed in the continuation of Box C.    ☐ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>13 June 2016 (13.06.16) | Date of mailing of the international search report<br>28 June 2016 (28.06.16) |
| --- | --- |
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**INTERNATIONAL SEARCH REPORT**

| International application No. |
| --- |
| PCT/JP2016/063384 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2010-108684 A  (Konica Minolta Holdings, Inc.), 13 May 2010 (13.05.2010), fig. 1 to 3 (Family: none) | 1-10 |

Form PCT/ISA/210 (continuation of second sheet) (January 2015)

**EP 3 197 250 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015093899 A
- JP 4240792 A